# FASCICULE DE BREVET EUROPEEN

(11) **EP 4 459 677 B1**
(45) Date de publication et mention de la délivrance du brevet: **11.03.2026**
(21) Numéro de dépôt: 24172073.9
(22) Date de dépôt: 24.04.2024
(51) Int. Cl.: H10D 89/60, H02H 9/04

(54) **DISPOSITIF DE PROTECTION CONTRE DES DECHARGES ELECTROSTATIQUES**
SCHUTZVORRICHTUNG GEGEN ELEKTROSTATISCHE ENTLADUNGEN
ELECTROSTATIC DISCHARGE PROTECTION DEVICE

(30) Priorité: 04.05.2023 FR 2304475
(43) Date de publication de la demande: 06.11.2024
(73) Titulaire: STMicroelectronics International N.V., 1228 Plan-les-Ouates, Geneva (CH)
(72) Inventeur: HEURTIER, Jérôme, 37000 TOURS (FR); GUITTON, Fabrice, 37380 MONNAIE (FR); LACONDE, Eric, 37100 TOURS (FR)
(74) Mandataire: Cabinet Beaumont

(56) Documents cités:
- WO-A1-2020/115413
- US-A1- 2011 212 595
- US-A1- 2015 207 312
- US-A1- 2017 221 875

## Description

### Domaine technique

La présente description concerne de façon générale les dispositifs électroniques, et plus particulièrement les dispositifs de protection contre des décharges électrostatiques.

### Technique antérieure

Les décharges électrostatiques peuvent produire, dans des circuits intégrés ou des composants électroniques qui les subissent, des effets délétères susceptibles de provoquer une détérioration irréversible de tout ou partie de leurs éléments constitutifs. Un circuit intégré ou un composant électronique peut ainsi souffrir de dysfonctionnements importants, voire être rendu totalement inopérant, suite à une décharge électrostatique. Le cas échéant, un remplacement du circuit ou du composant défectueux peut s'avérer nécessaire, nuisant ainsi à la fiabilité d'appareils électroniques intégrant de tels circuits ou composants.

Afin de se prémunir contre les conséquences néfastes des décharges électrostatiques, les circuits intégrés et les composants électroniques peuvent comporter des dispositifs de protection. Toutefois, les dispositifs de protection contre des décharges électrostatiques existants souffrent de divers inconvénients. En particulier, les dispositifs existants sont mal adaptés à des applications dans lesquelles ils sont censés à la fois protéger, contre des décharges électrostatiques, un composant ou circuit polarisé par une tension de l'ordre de quelques volts en fonctionnement nominal, et résister, en cas de court-circuit, à une tension bien plus importante que leur tension de polarisation nominale, par exemple une tension continue de l'ordre de plusieurs dizaines de volts.

Le document US 2017/221875 décrit un dispositif de diode de suppression de tension transitoire et son procédé de fabrication.

Le document US 2011/212595 décrit une structure de dispositif semiconducteur et des procédés de fabrication d'un tel dispositif.

Le document US 2015/207312 décrit un suppresseur de tension transitoire à faible capacité.

Le document WO 2020/115413 décrit un variateur électronique pour circuit basse tension.

### Résumé de l'invention

Il existe un besoin d'améliorer les dispositifs de protection contre des décharges électrostatiques existants. Il serait notamment souhaitable de fournir des dispositifs de protection contre des décharges électrostatiques parvenant à mieux concilier les aspects de résistance aux courts-circuits et de protection contre des décharges électrostatiques.

L'invention est définie par la revendication 1. Les revendications dépendantes couvrent des modes de réalisation et variantes de l'invention.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique illustrant un exemple de dispositif usuel de protection contre des décharges électrostatiques ;
la figure 2 est une caractéristique courant-tension du dispositif de la figure 1 ;
la figure 3 est un schéma électrique illustrant un exemple de dispositif de protection contre des décharges électrostatiques selon un mode de réalisation ;
la figure 4 est une caractéristique courant-tension du dispositif de la figure 3 ;
la figure 5 est un schéma électrique illustrant un autre exemple de dispositif de protection contre des décharges électrostatiques selon un mode de réalisation ;
la figure 6 est un schéma électrique illustrant un autre exemple de dispositif de protection contre des décharges électrostatiques selon un mode de réalisation ;
la figure 7 est un schéma électrique illustrant un autre exemple de dispositif de protection contre des décharges électrostatiques selon un mode de réalisation ; et
la figure 8 est un schéma électrique illustrant un autre exemple de dispositif de protection contre des décharges électrostatiques selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les composants ou circuits intégrés susceptibles d'être protégés contre des décharges électrostatiques par les dispositifs de la présente description ne seront pas détaillés, les modes de réalisation décrits étant compatibles avec les composants ou circuits intégrés usuellement protégés contre des décharges électrostatiques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

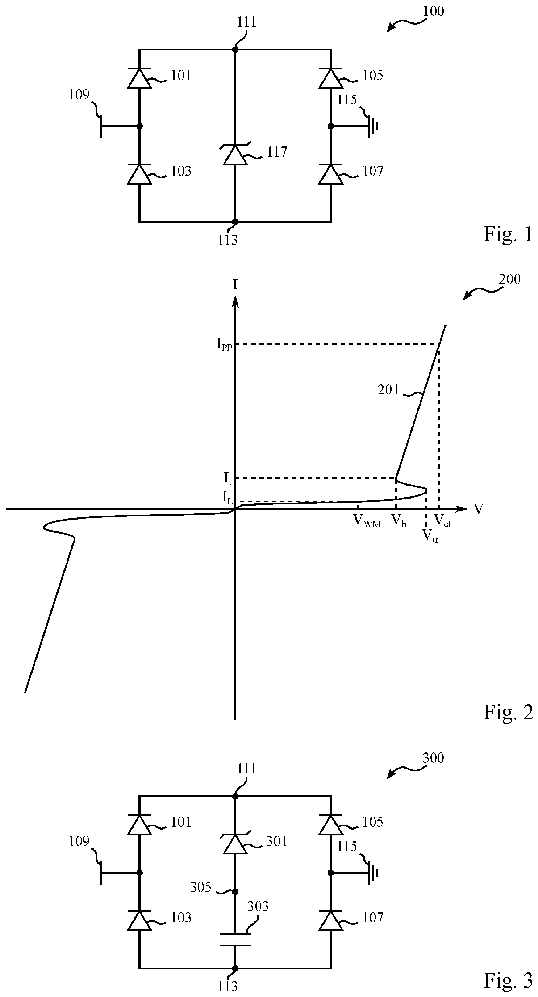

La figure 1 est un schéma électrique illustrant un exemple de dispositif 100 usuel de protection contre des décharges électrostatiques.

Dans l'exemple représenté, le dispositif 100 comprend quatre diodes 101, 103, 105 et 107. Plus précisément, dans l'exemple illustré en figure 1, la diode 101 comprend une électrode ou borne d'anode connectée à une borne 109 et une électrode ou borne de cathode connectée à un nœud interne 111 du dispositif 100. Dans cet exemple, la diode 103 comprend une électrode ou borne d'anode connectée à un autre nœud interne 113 du dispositif 100, distinct du nœud interne 111, et une électrode ou borne de cathode connectée à la borne 109. Par ailleurs, la diode 105 comprend une électrode ou borne d'anode connectée à une autre borne 115, distincte de la borne 109, et une électrode ou borne de cathode connectée au nœud interne 111, et la diode 107 comprend une électrode ou borne d'anode connectée au nœud interne 113 et une électrode ou borne de cathode connectée à la borne 115.

Les diodes 101, 103, 105 et 107 du dispositif 100 sont par exemple identiques entre elles, aux dispersions de fabrication près. À titre d'exemple, chaque diode 101, 103, 105, 107 présente une tension de claquage de l'ordre de 22 V.

La borne 109 est par exemple destinée à être connectée à une borne d'entrée, une borne de sortie ou une borne d'entrée-sortie d'un connecteur, d'un circuit intégré ou d'un composant électronique à protéger contre des décharges électrostatiques. La borne 109 est par exemple adaptée à être connectée à une borne de réception et/ou d'émission d'un signal numérique ou analogique. En fonctionnement nominal, la borne 109 est par exemple soumise à une tension inférieure ou égale à 5 V. À titre d'exemple, la borne 109 est destinée à être connectée à une borne ou broche de communication « SBU1 », « SBU2 », « CC1 » ou « CC2 » d'une fiche ou d'une prise d'un connecteur USB Type-C (USB-C). La fiche ou la prise fait par exemple partie d'un câble ou d'un dispositif électronique, par exemple un téléphone mobile, un smartphone, un objet connecté, une tablette tactile, etc.

La borne 115 est par exemple une borne d'application d'un potentiel de référence, par exemple la masse. À titre d'exemple, dans le cas où la borne 109 est destinée à être connectée à une fiche ou d'une prise USB Type-C, la borne 115 est destinée à être connectée à une borne ou broche « GND » de masse de la fiche ou de la prise.

Dans l'exemple représenté, le dispositif de protection contre des décharges électrostatiques 100 comprend en outre une diode 117, par exemple une diode Zener, reliant le nœud interne 111 au nœud interne 113. Plus précisément, dans l'exemple illustré en figure 1, la diode 117 comprend une électrode ou borne d'anode connectée au nœud interne 113 et une électrode ou borne de cathode connectée au nœud interne 111.

La diode 117 du dispositif 100 est par exemple dimensionnée de sorte qu'elle soit dans un état bloqué, c'est-à-dire non conducteur, lorsque la borne 109 est soumise à sa tension nominale de fonctionnement. Par ailleurs, la diode 117 est dimensionnée de sorte qu'elle soit dans l'état bloqué en cas de court-circuit. Dans le cas où la borne 109 est destinée à être connectée à une borne ou broche faisant partie d'un connecteur USB Type-C, un tel court-circuit peut par exemple se produire entre la borne ou broche à laquelle est connectée la borne 109 et une borne ou broche d'alimentation « Vbus » adjacente à cette borne. À titre d'exemple, dans un cas où la borne 109 est destinée à être soumise à une tension nominale inférieure ou égale à 5 V et est susceptible, en cas de court-circuit, d'être soumise à une tension comprise entre 16 et 22 V, par exemple de l'ordre de 20 V, la diode 117 présente par exemple un seuil de tension inverse égal à environ 22 V.

Dans le dispositif 100, les diodes 101, 103, 105 et 107 présentent une capacité strictement inférieure, par exemple au moins dix fois inférieure, à celle de la diode 117. Cela permet de « masquer » la capacité de la diode 117, évitant ainsi de perturber les signaux présents sur la borne 109.

Le fonctionnement du dispositif 100 est exposé plus en détail ci-dessous en relation avec la figure 2.

La figure 2 est une caractéristique courant-tension 200 du dispositif 100 de la figure 1. La caractéristique courant-tension de la figure 2 comprend plus précisément une courbe 201 illustrant des variations d'intensité (I) d'un courant parcourant le dispositif 100 en fonction d'une tension de polarisation (V) appliquée entre les bornes 109 et 115. La courbe 201 comprend des parties gauche et droite correspondant respectivement au cas où la tension V est négative et au cas où la tension V est positive. Les parties gauche et droite de la courbe 201 sont par exemple sensiblement identiques, au signe près. Pour simplifier, seule la partie droite de la courbe 201 sera détaillée ci-après, la transposition de la description à la partie gauche de la courbe 201 étant à la portée de la personne du métier à partir des indications ci-dessous.

En fonctionnement nominal ou en cas de court-circuit, la tension de polarisation V peut par exemple prendre des valeurs comprises entre 0 V et une tension limite V_{WM}. La tension limite V_{WM} correspond par exemple à une valeur de tension V maximale prévue pour une application donnée. La tension limite V_{WM} est par exemple de l'ordre de 20 V, dans un cas où la borne 109 du dispositif 100 est destinée à être connectée à une borne de communication « SBU1 », « SBU2 », « CC1 » ou « CC2 » faisant partie d'un connecteur USB Type-C et où la tension appliquée aux bornes « Vbus » du connecteur, susceptibles de former un court-circuit avec la borne 109, est égale à environ 20 V. Lorsque le dispositif 100 est polarisé sous cette tension limite V_{WM}, il est parcouru par un faible courant de fuite I_{L}.

En cas de surtension provenant par exemple d'une décharge électrostatique, la tension de polarisation V peut temporairement excéder une tension de seuil Vₜᵣ. La tension de seuil Vₜᵣ correspond ici à une tension de déclenchement de la protection. Afin d'éviter tout risque de déclenchement intempestif de cette protection et tout risque de dégradation irréversible en cas de court-circuit, le dispositif 100, en particulier la diode 117, est dimensionné de sorte que la tension de seuil Vₜᵣ soit supérieure à la tension limite V_{WM} prévue dans l'application considérée.

Dans un cas où la tension de seuil Vₜᵣ est dépassée, c'est-à-dire une fois la protection déclenchée par exemple en raison d'une décharge électrostatique appliquant, entre les bornes 109 et 115, une tension V supérieure à Vₜᵣ, la tension V redescend légèrement jusqu'à une valeur de tension de maintien Vₕ. La tension de maintien Vₕ correspond à la tension V minimale pouvant être atteinte après déclenchement de la protection. À la tension de maintien Vₕ, un courant Iₜ supérieur au courant de fuite I_{L} parcourt la diode 117.

La décharge électrostatique peut néanmoins être suffisamment importante pour que la tension de polarisation V du dispositif 100 continue à augmenter même après le déclenchement de la protection. Cette augmentation de la tension V s'accompagne d'une augmentation du courant I traversant la diode 117. Le courant I qui traverse la diode 117 est alors sensiblement proportionnel à une différence entre la tension de polarisation V et la tension de maintien Vₕ selon une relation du type I = (V-Vₕ)/R_{d}, où R_{d} est appelée résistance dynamique de la protection.

Comme illustré en figure 1, la valeur de la tension de polarisation V peut alors augmenter jusqu'à une valeur V_{cl} appelée tension de blocage (« clamping voltage », en anglais) ou d'écrêtage. La tension V_{cl} correspond à un courant maximum I_{PP} acceptable par la protection (« peak pulse current », en anglais).

Un inconvénient du dispositif 100 tient au fait que, pour permettre d'évacuer des décharges électrostatiques tout en étant capable de résister aux courts-circuits, la diode 117 doit présenter une tension de déclenchement Vₜᵣ bien supérieure, par exemple de l'ordre de dix fois supérieure, à la tension nominale de la borne 109 en l'absence de court-circuit. Cela nuit à l'évacuation des décharges électrostatiques par le dispositif 100, car la tension appliquée entre les bornes 109 et 115 en cas de décharge électrostatique croît à partir d'une valeur de la tension de maintien Vₕ elle aussi de l'ordre de dix fois supérieure à la tension nominale. Il en résulte que le ou les circuits et/ou composants protégés par le dispositif 100 peuvent être soumis à des tensions V élevées, par exemple de l'ordre de 25 V, en cas de décharge électrostatique, ce qui est susceptible de les endommager.

La figure 3 est un schéma électrique illustrant un exemple de dispositif 300 de protection contre des décharges électrostatiques selon un mode de réalisation.

Le dispositif 300 de la figure 3 comprend des éléments communs avec le dispositif 100 de la figure 1. Ces éléments communs ne seront pas détaillés à nouveau ci-après. Le dispositif 300 de la figure 3 diffère du dispositif 100 de la figure 1 en ce que le dispositif 300 comprend une diode 301, par exemple une diode Zener, et un élément capacitif 303 en série entre les nœuds internes 111 et 113. Dans l'exemple représenté, la diode 301 et l'élément capacitif 303 sont connectés en série entre le nœud 111 et le nœud 113. Plus précisément, dans l'exemple illustré en figure 3, la diode 301 comprend une électrode ou borne d'anode connectée à un autre nœud interne 305, distinct des nœuds 113 et 111, et une électrode ou borne de cathode connectée au nœud interne 111. L'élément capacitif 303 comprend une électrode ou borne connectée au nœud interne 305 et une autre électrode ou borne connectée au nœud interne 113.

La diode 301 du dispositif 300 est par exemple analogue à la diode 117 du dispositif 100, mais diffère de la diode 117 en ce qu'elle présente une tension de déclenchement strictement inférieure, par exemple environ quatre fois inférieure, à celle de la diode 117. À titre d'exemple, la diode 301 présente une tension de déclenchement ou tension inverse de l'ordre de 5 V, en valeur absolue, dans un cas où la tension nominale appliquée entre les bornes 109 et 115 est inférieure ou égale à 5 V, en valeur absolue.

Par ailleurs, la figure 3 illustre un exemple où la diode 301 relie le nœud 111 au nœud 305 et où l'élément capacitif 303 relie le nœud 305 au nœud 113. Cet exemple n'est toutefois pas limitatif, les positions de la diode 301 et de l'élément capacitif 303 dans le dispositif 300 pouvant, à titre de variante, être interverties, de sorte que la diode 301 relie le nœud 305 au nœud 113, l'anode et la cathode de la diode 301 étant alors respectivement connectées aux nœuds 113 et 305, et de sorte que l'élément capacitif 303 relie le nœud 111 au nœud 305.

L'élément capacitif 303 du dispositif 300 est plus précisément un condensateur comprenant deux électrodes électriquement conductrices ou armatures, par exemple deux électrodes métalliques parallèles entre elles, séparées l'une de l'autre par un matériau diélectrique. À titre d'exemple, le dispositif 300 peut être réalisé en tout ou partie à partir de composants discrets. Le dispositif 300 présente par exemple une structure monolithique à l'exception de l'élément capacitif 303, formé par un composant discret. Cela permet par exemple avantageusement d'utiliser le dispositif 300 muni soit de l'élément capacitif 303, par exemple dans un cas où la borne 109 est susceptible de subir un court-circuit, soit d'une piste conductrice substituée à l'élément capacitif 303, par exemple dans un cas où la borne 109 n'est pas destinée à pouvoir être soumise à un court-circuit. À titre de variante, le dispositif 300 peut présenter une structure entièrement monolithique, c'est-à-dire une structure dont les éléments sont complètement intégrés, l'élément capacitif 303 étant alors par exemple un condensateur de type MIM (de l'anglais « Metal Insulator Metal » - métal isolant métal) formé dans un empilement de niveaux électriquement conducteurs, par exemple des couches métalliques, séparés les uns des autres par des niveaux électriquement isolants, par exemple des couches diélectriques.

À titre d'exemple, l'élément capacitif 303 présente une capacité comprise entre 100 nF et 10 µF.

Bien que cela n'ait pas été détaillé en figure 3, le dispositif 300 peut en outre comprendre un composant ou un circuit de décharge de l'élément capacitif 303, par exemple une résistance associée en parallèle de l'élément capacitif 303. À titre de variante, un moyen de décharge de l'élément capacitif 303 du dispositif 300 peut comprendre un transistor, par exemple un transistor MOS (de l'anglais « Metal-Oxide-Semiconductor » - métal oxyde semiconducteur), dont une borne de conduction, par exemple une électrode de drain, est connectée au nœud 305, dont une autre borne de conduction, par exemple une électrode de source, est connectée à la borne 113 et dont une borne de commande, par exemple une électrode de grille, est connectée à un circuit de commande.

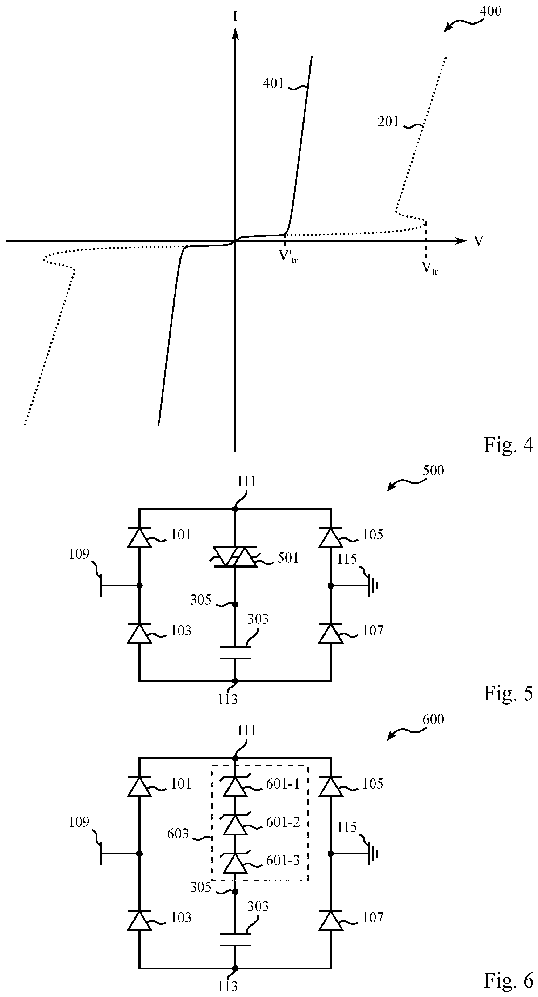

La figure 4 est une caractéristique courant-tension du dispositif 300 de la figure 3. La caractéristique courant-tension de la figure 4 comprend plus précisément une courbe 401 illustrant des variations d'intensité (I) d'un courant parcourant le dispositif 300 en fonction d'une tension de polarisation (V) appliquée entre les bornes 109 et 115 du dispositif 300. La courbe 401 illustre un fonctionnement « dynamique » du dispositif 300, c'est-à-dire lorsque le dispositif 300 est soumis à une décharge électrostatique, l'élément capacitif 303 se comportant alors comme un court-circuit, tandis que, en fonctionnement « statique », c'est-à-dire en l'absence de décharge électrostatique, l'élément capacitif 303 se comporte comme un circuit ouvert et la caractéristique courant-tension du dispositif 300 présente alors une allure différente de celle de la courbe 401. La courbe 401 comprend des parties gauche et droite correspondant respectivement au cas où la tension V est négative et au cas où la tension V est positive. Les parties gauche et droite de la courbe 401 sont par exemple sensiblement identiques, au signe près. Pour simplifier, seule la partie droite de la courbe 401 sera détaillée ci-après, la transposition de la description à la partie gauche de la courbe 401 étant à la portée de la personne du métier à partir des indications ci-dessous. Afin de mettre en exergue les différences entre le dispositif 100 de la figure 1 et le dispositif 300 de la figure 3, la courbe 201 a été représentée en figure 4 à titre de comparaison. Contrairement à la courbe 401 qui illustre uniquement le fonctionnement dynamique du dispositif 300, la courbe 201 illustre par exemple à la fois le fonctionnement statique et le fonctionnement dynamique du dispositif 100.

Le dispositif 300 de la figure 3 présente une tension de seuil V'ₜᵣ strictement inférieure, par exemple au moins deux fois inférieure, par exemple environ cinq fois inférieure, à la tension de seuil Vₜᵣ du dispositif 100 de la figure 1. Cela permet au dispositif 300 d'évacuer des décharges électrostatiques plus efficacement que le dispositif 100, car la tension V appliquée entre les bornes 109 et 115 du dispositif 300 en cas de décharge électrostatique croît à partir d'une valeur plus faible que dans le cas du dispositif 100, par exemple une valeur de l'ordre de la tension nominale appliquée à la borne 109. Par ailleurs, le dispositif 300 présente une résistance dynamique R_{d} inférieure à celle du dispositif 100, ce qui permet au dispositif 300 d'atteindre des performances plus élevées en termes d'évacuation des décharges électrostatiques que le dispositif 100, notamment une tension V inférieure, pour une même valeur de courant I.

En cas de court-circuit résultant par exemple de l'application, sur la borne 109, d'une tension continue supérieure à la tension nominale, un courant commence par circuler entre la borne 109 et la borne 115, à travers la diode 101, la diode 301, l'élément capacitif 303 et la diode 107. Une fois l'élément capacitif 303 chargé, celui-ci se comporte alors comme un circuit ouvert et la circulation de courant est interrompue. Cela permet avantageusement d'éviter toute dégradation irréversible de la diode 301 en cas de court-circuit.

Un avantage du dispositif 300 tient donc au fait qu'il permet d'évacuer des décharges électrostatiques de manière plus efficace que le dispositif 100, tout en demeurant protégé contre des courts-circuits.

La figure 5 est un schéma électrique illustrant un autre exemple de dispositif 500 de protection contre des décharges électrostatiques selon un mode de réalisation. Le dispositif 500 de la figure 5 comprend des éléments communs avec le dispositif 300 de la figure 3. Ces éléments communs ne seront pas détaillés à nouveau ci-après. Le dispositif 500 de la figure 5 diffère du dispositif 300 de la figure 3 en ce que le dispositif 500 comprend une diode à retournement 501, également appelée diode de Shockley, reliant le nœud interne 111 au nœud interne 305.

La tension V appliquée entre les bornes 109 et 115 du dispositif 500 en cas de décharge électrostatique croît à partir d'une valeur encore plus faible que dans le cas du dispositif 300, par exemple une valeur sensiblement nulle. Cela permet avantageusement au dispositif 500 d'atteindre des performances en termes de protection contre des décharges électrostatiques encore plus élevées que celles du dispositif 300.

À titre d'exemple, pour un courant I égal à environ 16 A correspondant par exemple à une décharge électrostatique de l'ordre de 8 kV sur la borne 109, la tension V entre les bornes 109 et 115 du dispositif 500 est égale à environ 13 V.

La figure 6 est un schéma électrique illustrant un autre exemple de dispositif 600 de protection contre des décharges électrostatiques selon un mode de réalisation. Le dispositif 600 de la figure 6 comprend des éléments communs avec le dispositif 300 de la figure 3. Ces éléments communs ne seront pas détaillés à nouveau ci-après. Le dispositif 600 de la figure 6 diffère du dispositif 300 de la figure 3 en ce que le dispositif 600 comprend plusieurs diodes 601 en série entre les nœuds internes 305 et 111. Plus précisément, dans l'exemple illustré en figure 6, le dispositif 600 comprend trois diodes 601-1, 601-2 et 601-3, par exemple des diodes Zener, associées en série entre le nœud 305 et le nœud 111. Dans cet exemple, la diode 601-1 comprend une électrode ou borne d'anode connectée à une électrode ou borne de cathode de la diode 601-2, et une électrode ou borne de cathode connectée au nœud 111. Par ailleurs, la diode 601-2 comprend une électrode ou borne d'anode connectée à une électrode ou borne de cathode de la diode 601-3, et la diode 601-3 comprend une électrode ou borne d'anode connectée au nœud 305. Bien que la figure 6 illustre un exemple dans lequel le dispositif 600 comprend un groupe 603 de trois diodes 601-1, 601-2 et 601-3, le groupe 603 peut bien entendu comprendre un nombre quelconque, supérieur ou égal à deux, de diodes reliant le nœud 305 au nœud 111.

Dans le dispositif 600, chaque diode 601-1, 601-2, 601-3 est soumise, à ses bornes, à une tension sensiblement égale au tiers de la tension appliquée entre les bornes de la diode 301 du dispositif 300. Dit autrement, la tension appliquée entre les nœuds 111 et 305 est répartie entre les diodes 601-1, 601-2 et 601-3. Cela permet avantageusement au dispositif 600 d'atteindre des tensions d'écrêtage V_{cl} plus importantes que le dispositif 300, par exemple dans des cas où il serait souhaitable d'obtenir une tension Vcl supérieure à celle qui serait obtenue en utilisant une seule diode, par exemple la diode 301 du dispositif 300. Cela permet en outre de diminuer la tension aux bornes de chaque diode 601-1, 601-2, 601-3 du dispositif 600 par rapport à la tension aux bornes de la diode 301 du dispositif 300, donc d'atténuer des inconvénients liés à une variation de capacité des diodes en fonction de la tension appliquée à leurs bornes. Il en résulte par exemple, dans le dispositif 600, une baisse d'intensité des harmoniques, notamment des harmoniques impairs, plus particulièrement de l'harmonique de rang 3 (H3), par rapport au dispositif 300.

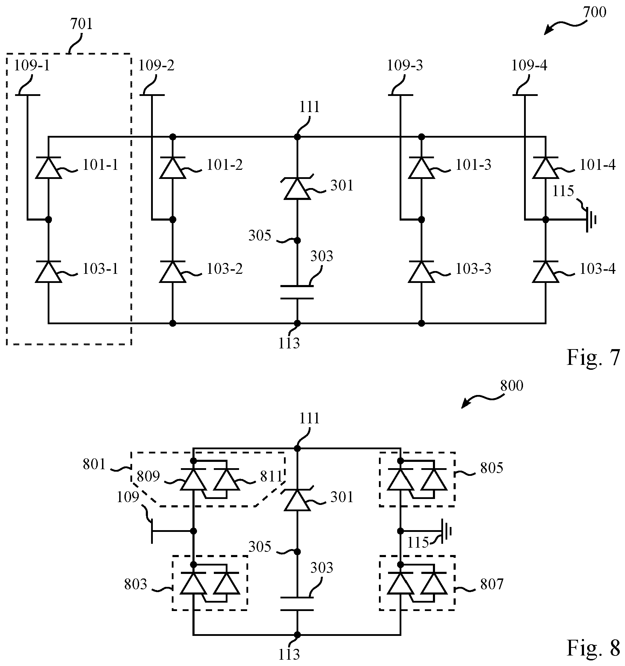

La figure 7 est un schéma électrique illustrant un autre exemple de dispositif 700 de protection contre des décharges électrostatiques selon un mode de réalisation. Le dispositif 700 de la figure 7 comprend des éléments communs avec le dispositif 300 de la figure 3. Ces éléments communs ne seront pas détaillés à nouveau ci-après. Le dispositif 700 de la figure 7 diffère du dispositif 300 de la figure 3 en ce que le dispositif 700 est dépourvu des diodes 105 et 107 et en ce que le dispositif 700 comprend plusieurs bornes 109 (quatre bornes 109-1, 109-2, 109-3 et 109-4, dans l'exemple illustré) connectées chacune entre deux diodes 103 et 101 en série. L'une des bornes 109 du dispositif 700 (la borne 109-4, dans l'exemple illustré) est connectée au nœud 115 d'application du potentiel de référence.

Plus précisément, dans l'exemple représenté, le dispositif 700 comprend plusieurs branches 701 (quatre branches 701, dans l'exemple illustré) comprenant chacune la borne 109 (109-1, 109-2, 109-3 ou 109-4) connectée à l'anode de la diode 101 (101-1, 101-2, 101-3 ou 101-4) et à la cathode de la diode 103 (103-1, 103-2, 103-3 ou 103-4), l'anode de la diode 103 étant connectée au nœud interne 113 et la cathode de la diode 101 étant connectée au nœud interne 111. Bien que la figure 7 illustre un exemple dans lequel le dispositif 700 comprend quatre branches 701, le dispositif 700 peut, à titre de variante, comprendre un nombre quelconque, supérieur ou égal à deux, de branches 701. Dans l'exemple illustré, la diode 101, la diode 103 et la borne 109 de chaque branche 701 sont distinctes de la diode 101, de la diode 103 et de la borne 109 des autres branches 701 du dispositif 700.

À titre d'exemple, les bornes 109-1, 109-2, 109-3 et 109-4 sont destinées à être connectées à des bornes ou broches distinctes d'un connecteur USB Type-C.

Le dispositif 700 présente un fonctionnement et des avantages analogues à ceux du dispositif 300 de la figure 3. Un avantage supplémentaire du dispositif 700 tient au fait que le dispositif 700 permet de mutualiser la diode 301 et l'élément capacitif 303 pour plusieurs bornes 109. Cela permet ainsi au dispositif 700 de présenter une complexité, un coût et un encombrement inférieurs à ceux qui seraient obtenus en utilisant un dispositif 300 pour chaque borne 109 (109-1, 109-2, 109-3 et 109-4) à protéger.

La figure 8 est un schéma électrique illustrant un autre exemple de dispositif 800 de protection contre des décharges électrostatiques selon un mode de réalisation. Le dispositif 800 de la figure 8 comprend des éléments communs avec le dispositif 300 de la figure 3. Ces éléments communs ne seront pas détaillés à nouveau ci-après. Le dispositif 800 de la figure 8 diffère du dispositif 300 de la figure 3 en ce que les éléments de redressement, constitués par les diodes 101, 103, 105 et 107 dans le cas du dispositif 300, sont, dans le cas du dispositif 800, substitués respectivement par des ensembles 801, 803, 805 et 807 comprenant chacun un thyristor 809 et une diode 811. Dans chaque ensemble 801, 803, 805, 807, le thyristor 809 comprend une gâchette d'anode reliée, par la diode 811, à une électrode ou borne de cathode du thyristor 809. Plus précisément, la diode 811 comprend une électrode ou borne d'anode connectée à la gâchette d'anode du thyristor 809, et une électrode ou borne de cathode connectée à l'électrode ou borne de cathode du thyristor 809.

Chaque ensemble 801, 803, 805, 807 comprend une électrode ou borne d'anode correspondant à une électrode ou borne d'anode du thyristor 809 et une électrode ou borne de cathode correspondant à l'électrode ou borne de cathode du thyristor 809. Ce qui a été décrit précédemment en relation avec les électrodes ou bornes d'anode et de cathode des diodes 101, 103, 105 et 107 du dispositif 300 de la figure 3, en particulier les connexions de ces électrodes ou bornes avec les autres bornes et nœuds du dispositif 300, est transposable par la personne du métier aux électrodes ou bornes d'anode et de cathode des ensembles 801, 803, 805 et 807, respectivement, du dispositif 800 de la figure 8.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier :
- les modes de réalisation des dispositifs 500 et 600 pourraient être combinés, tout ou partie des diodes 601-1, 601-2 et 601-3 du dispositif 600 étant alors remplacée par une diode à retournement analogue à la diode 501 du dispositif 500 ;
- les modes de réalisation des dispositifs 500 et 700 pourraient être combinés, la diode 301 du dispositif 700 étant alors par exemple remplacée par une diode à retournement analogue ou identique à la diode 501 du dispositif 500 ; et
- les modes de réalisation des dispositifs 600 et 700 pourraient être combinés, et éventuellement combinés avec le mode de réalisation du dispositif 500, la diode 301 du dispositif 700 étant alors par exemple remplacée par un groupe 603 comprenant une pluralité de diodes analogues ou identiques aux diodes 601-1, 601-2 et 601-3 du dispositif 600 ou par un groupe analogue au groupe 603 mais comprenant une pluralité de diodes à retournement par exemple analogues à la diode 501 du dispositif 500.

Par ailleurs, le mode de réalisation du dispositif 800 pourrait être combiné avec chacun des modes de réalisation des dispositifs 500, 600 et 700, chaque diode 101, 103, 105, 107 de ces dispositifs pouvant être remplacée par un ensemble identique ou analogue aux ensembles 801, 803, 805 et 807, c'est-à-dire par un élément de redressement comprenant un thyristor 809 dont la gâchette d'anode est reliée à son électrode ou borne de cathode par une diode 811.

Bien que des dispositifs de protection 300, 500, 600, 700 et 800 bidirectionnels, capables d'évacuer indifféremment des surtensions positives ou négatives, aient été décrits ci-dessus en relation avec les figures 3, 5, 6, 7 et 8, il serait possible, à partir des indications de la présente description, de réaliser des dispositifs de protection unidirectionnels, capables d'évacuer uniquement des surtensions positives ou négatives. De tels dispositifs peuvent par exemple être obtenus en connectant la borne 115 d'application du potentiel de référence au nœud 113 plutôt qu'au nœud 109 dans chacun des dispositifs 300, 500, 600, 700 et 800.

Enfin, la mise en œuvre pratique des modes de réalisation et variantes décrits est à la portée de la personne du métier à partir des indications fonctionnelles données ci-dessus. En particulier, la personne du métier est capable de prévoir un moyen de décharge de l'élément capacitif 303 à partir des indications de la présente description.

La personne du métier est en outre capable de déterminer les valeurs des tensions de seuil des diodes 101, 103, 105, 107, 117, 301, 501, 601-1, 601-2 et 601-3 et la capacité de l'élément capacitif 303 en fonction de l'application, par exemple à l'aide d'outils de simulation numérique.

Par ailleurs, bien que la présente description détaille des exemples d'application dans lesquels les bornes 109 et 115 correspondent à des bornes ou broches d'un connecteur USB Type-C, les modes de réalisation décrits ne se limitent pas à cette application mais peuvent être mis en œuvre dans tout type de dispositif électronique, composant, circuit, etc. susceptible d'être protégé contre des décharges électrostatiques et de subir des courts-circuits.

Enfin, les positions de l'élément capacitif 303 d'une part, et de la diode à retournement 501, du groupe 603 de diodes 601 ou de la diode 301 d'autre part, peuvent être interverties dans les dispositifs de protection 500, 600 et 700, respectivement.

## Revendications

1. Dispositif (300 ; 500 ; 600 ; 700 ; 800) de protection contre des décharges électrostatiques comprenant :
- au moins un premier élément de redressement (101 ; 101-1, 101-2, 101-3, 101-4 ; 801) comportant une anode connectée à une première borne (109 ; 109-1, 109-2, 109-3, 109-4) et une cathode connectée à un premier nœud (111) du dispositif ;
- au moins un deuxième élément de redressement (103 ; 103-1, 103-2, 103-3, 103-4) comportant une anode connectée à un deuxième nœud (113) du dispositif et une cathode connectée à la première borne (109) ; et
- au moins une diode Zener (301 ; 601-1, 601-2, 601-3) ou au moins une diode de Shockley (501) connectée en série avec un élément capacitif (303) entre les premier et deuxième nœuds (111, 113),
**caractérisé en ce que** l'élément capacitif (303) est un condensateur comprenant deux électrodes électriquement conductrices séparées l'une de l'autre par un matériau diélectrique.

2. Dispositif (300 ; 500 ; 600 ; 700) selon la revendication 1, dans lequel les premier et deuxième éléments de redressement (101, 103) sont des diodes.

3. Dispositif (800) selon la revendication 1, dans lequel les premier et deuxième éléments de redressement (801, 803) comprennent chacun un thyristor (809) et une diode (811) reliant une gâchette d'anode du thyristor à une cathode du thyristor.

4. Dispositif (300 ; 500 ; 600 ; 800) selon l'une quelconque des revendications 1 à 3, comprenant un seul premier élément de redressement (101 ; 801) et un seul deuxième élément de redressement (103 ; 803), le dispositif comprenant en outre :
- un troisième élément de redressement (105 ; 805) comportant une anode connectée à une deuxième borne (115) et une cathode connectée au premier nœud (111) ; et
- un quatrième élément de redressement (107 ; 807) comportant une anode connectée au deuxième nœud (113) et une cathode connectée à la deuxième borne (115).

5. Dispositif (300 ; 500 ; 600 ; 800) selon la revendication 4, dans lequel la deuxième borne (115) est une borne d'application d'un potentiel de référence.

6. Dispositif (700) selon l'une quelconque des revendications 1 à 3, comprenant au moins deux branches (701) comportant chacune un seul premier élément de redressement (101-1, 101-2, 101-3, 101-4 ; 801), une seule deuxième diode (103-1, 103-2, 103-3, 103-4 ; 803) et une seule première borne (109-1, 109-2, 109-3, 109-4) distinctes des premiers éléments de redressement, des deuxièmes éléments de redressement et des premières bornes des autres branches.

7. Dispositif (700) selon la revendication 6, dans lequel l'une des premières bornes (109-1, 109-2, 109-3, 109-4) est connectée à une troisième borne (115) d'application d'un potentiel de référence.

8. Dispositif (300 ; 500 ; 700 ; 800) selon l'une quelconque des revendications 1 à 7, dans lequel ladite au moins une diode Zener ou au moins une diode de Shockley est une unique diode Zener (301).

9. Dispositif (300 ; 500 ; 700 ; 800) selon la revendication 8, dans lequel ladite diode Zener (301) comporte une anode connectée à un troisième nœud (305) et une cathode connectée au premier nœud (111), l'élément capacitif (303) comprenant une première borne connectée au troisième nœud (305) et une deuxième borne connectée au deuxième nœud (113) .

10. Dispositif (300 ; 500 ; 700 ; 800) selon la revendication 8, dans lequel ladite diode Zener (301) comporte une anode connectée au deuxième nœud (113) et une cathode connectée à un troisième nœud (305), l'élément capacitif (303) comprenant une première borne connectée au troisième nœud (305) et une deuxième borne connectée au premier nœud (111).

11. Dispositif (500 ; 700 ; 800) selon l'une quelconque des revendications 1 à 7, dans lequel ladite au moins une diode Zener ou au moins une diode de Shockley est une unique diode de Shockley (501).

12. Dispositif (600 ; 700 ; 800) selon l'une quelconque des revendications 1 à 7, dans lequel ladite au moins une diode Zener ou au moins une diode de Shockley comprend au moins deux diodes Zener ou au moins deux diodes de Shockley.

13. Dispositif (300 ; 500 ; 600 ; 700 ; 800) selon l'une quelconque des revendications 1 à 12, dans lequel les première et deuxième bornes (109, 115) sont destinées à être connectées à des bornes d'un connecteur, par exemple un connecteur USB Type-C.

14. Dispositif électronique, de préférence smartphone, objet connecté, tablette tactile ou câble USB Type-C, comprenant au moins un dispositif (300 ; 500 ; 600 ; 700 ; 800) de protection contre des décharges électrostatiques selon l'une quelconque des revendications 1 à 13.

## Patentansprüche

1. Eine Vorrichtung (300; 500; 600; 700; 800) zum Schutz vor elektrostatischen Entladungen, die Folgendes aufweist:
- mindestens ein erstes Gleichrichtelement (101; 101-1, 101-2, 101-3, 101-4; 801), das eine Anode, die mit einem ersten Anschluss (109; 109-1, 109-2, 109-3, 109-4) verbunden ist, und eine Kathode, die mit einem ersten Knoten (111) der Vorrichtung verbunden ist, aufweist;
- mindestens ein zweites Gleichrichtelement (103; 103-1, 103-2, 103-3, 103-4), das eine Anode, die mit einem zweiten Knoten (113) der Vorrichtung verbunden ist, und eine Kathode, die mit dem ersten Anschluss (109) verbunden ist, aufweist; und
- mindestens eine Zener-Diode (301; 601-1, 601-2, 601-3) oder mindestens eine Shockley-Diode (501), die mit einem kapazitiven Element (303) zwischen dem ersten und dem zweiten Knoten (111, 113) in Reihe geschaltet ist,
**dadurch gekennzeichnet, dass**
das kapazitive Element (303) ein Kondensator ist, der zwei elektrisch leitende Elektroden umfasst, die durch ein dielektrisches Material voneinander getrennt sind.

2. Die Vorrichtung (300; 500; 600; 700) gemäß Anspruch 1, wobei das erste und das zweite Gleichrichtelement (101, 103) Dioden sind.

3. Die Vorrichtung (800) gemäß Anspruch 1, wobei das erste und das zweite Gleichrichtelement (801, 803) jeweils einen Thyristor (809) und eine Diode (811), die ein Anodengate des Thyristors mit einer Kathode des Thyristors koppelt, aufweisen.

4. Die Vorrichtung (300; 500; 600; 800) gemäß einem der Ansprüche 1 bis 3, die ein einzelnes erstes Gleichrichtelement (101; 801) und ein einzelnes zweites Gleichrichtelement (103; 803) aufweist, wobei die Vorrichtung ferner aufweist:
- ein drittes Gleichrichtelement (105; 805), das eine Anode, die mit einem zweiten Anschluss (115) verbunden ist, und einer Kathode, die mit dem ersten Knoten (111) verbunden ist, aufweist; und
- ein viertes Gleichrichtelement (107; 807), das eine Anode, die mit dem zweiten Knoten (113) verbunden ist, und einer Kathode, die mit dem zweiten Anschluss (115) verbunden ist, aufweist.

5. Die Vorrichtung (300; 500; 600; 800) gemäß Anspruch 4, wobei der zweite Anschluss (115) ein Anschluss zum Anlegen eines Referenzpotentials ist.

6. Die Vorrichtung (700) gemäß einem der Ansprüche 1 bis 3, aufweisend mindestens zwei Zweige (701), die jeweils ein einzelnes erstes Gleichrichtelement (101-1, 101-2, 101-3, 101-4; 801), eine einzelne zweite Diode (103-1, 103-2, 103-3, 103-4; 803) und einen einzigen ersten Anschluss (109-1, 109-2, 109-3, 109-4) aufweisen, die sich von den ersten Gleichrichtelementen, den zweiten Gleichrichtelementen und den Anschlüssen der anderen Zweige unterscheiden.

7. Die Vorrichtung (700) gemäß Anspruch 6, wobei einer der ersten Anschlüsse (109-1, 109-2, 109-3, 109-4) mit einem dritten Anschluss (115) zum Anlegen eines Referenzpotentials verbunden ist.

8. Die Vorrichtung (300; 500; 700; 800) gemäß einem der Ansprüche 1 bis 7, wobei die mindestens eine Zener-Diode oder die mindestens eine Shockley-Diode eine einzelne Zener-Diode (301) ist.

9. Die Vorrichtung (300; 500; 700; 800) gemäß Anspruch 8, wobei die Zener-Diode (301) eine mit einem dritten Knoten (305) verbundene Anode und eine mit dem ersten Knoten (111) verbundene Kathode aufweist, wobei das kapazitive Element (303) einen mit dem dritten Knoten (305) verbundenen ersten Anschluss und einen mit dem zweiten Knoten (113) verbundenen zweiten Anschluss aufweist.

10. Die Vorrichtung (300; 500; 700; 800) gemäß Anspruch 8, wobei die Zener-Diode (301) eine mit dem zweiten Knoten (113) verbundene Anode und eine mit einem dritten Knoten (305) verbundene Kathode aufweist, wobei das kapazitive Element (303) einen mit dem dritten Knoten (305) verbundenen ersten Anschluss und einen mit dem ersten Knoten (111) verbundenen zweiten Anschluss aufweist.

11. Die Vorrichtung (500; 700; 800) gemäß einem der Ansprüche 1 bis 7, wobei die mindestens eine Zener-Diode oder die mindestens eine Shockley-Diode eine einzelne Shockley-Diode (501) ist.

12. Die Vorrichtung (600; 700; 800) gemäß einem der Ansprüche 1 bis 7, wobei die mindestens eine Zener-Diode oder die mindestens eine Shockley-Diode mindestens zwei Zener-Dioden oder mindestens zwei Shockley-Dioden aufweisen.

13. Die Vorrichtung (300; 500; 600; 700; 800) gemäß einem der Ansprüche 1 bis 12, wobei der erste und der zweite Anschluss (109, 115) dazu bestimmt sind, mit Anschlüssen eines Steckverbinders, beispielsweise eines USB-Steckverbinders vom Typ C, verbunden zu werden.

14. Ein elektronisches Gerät, vorzugsweise ein Smartphone, vernetztes Objekt, Touch-Tablet oder USB-Kabel vom Typ C, aufweisend mindestens eine Vorrichtung (300; 500; 600; 700; 800) zum Schutz vor elektrostatischen Entladungen gemäß einem der Ansprüche 1 bis 13.

## Claims

1. Device (300; 500; 600; 700; 800) of protection against electrostatic discharges comprising:
- at least one first rectifying element (101; 101-1, 101-2, 101-3, 101-4; 801) comprising an anode connected to a first terminal (109; 109-1, 109-2, 109-3, 109-4) and a cathode connected to a first node (111) of the device;
- at least one second rectifying element (103; 103-1, 103-2, 103-3, 103-4) comprising an anode connected to a second node (113) of the device and a cathode connected to the first terminal (109); and
- at least one Zener diode (301; 601-1, 601-2, 601-3) or at least one Shockley diode (501) series-connected with a capacitive element (303) between the first and second nodes (111, 113),
**characterized in that** the capacitive element (303) is a capacitor comprising two electrically conductive electrodes separated from each other by a dielectric material.

2. Device (300; 500; 600; 700) according to claim 1, wherein the first and second rectifying elements (101, 103) are diodes.

3. Device (800) according to claim 1, wherein the first and second rectifying elements (801, 803) each comprise a thyristor (809) and a diode (811) coupling an anode gate of the thyristor to a cathode of the thyristor.

4. Device (300; 500; 600; 800) according to any of claims 1 to 3, comprising a single first rectifying element (101; 801) and a single second rectifying element (103; 803), the device further comprising:
- a third rectifying element (105; 805) comprising an anode connected to a second terminal (115) and a cathode connected to the first node (111); and
- a fourth rectifying element (107; 807) comprising an anode connected to the second node (113) and a cathode connected to the second terminal (115).

5. Device (300; 500; 600; 800) according to claim 4, wherein the second terminal (115) is a terminal of application of a reference potential.

6. Device (700) according to any of claims 1 to 3, comprising at least two branches (701) each comprising a single first rectifying element (101-1, 101-2, 101-3, 101-4; 801), a single second diode (103-1, 103-2, 103-3, 103-4; 803), and a single first terminal (109-1, 109-2, 109-3, 109-4) distinct from the first rectifying elements, from the second rectifying elements, and from the terminals of the other branches.

7. Device (700) according to claim 6, wherein one of the first terminals (109-1, 109-2, 109-3, 109-4) is connected to a third terminal (115) of application of a reference potential.

8. Device (300; 500; 700; 800) according to any of claims 1 to 7, wherein said at least one Zener diode or at least one Shockley diode is a single Zener diode (301).

9. Device (300; 500; 700; 800) according to claim 8, wherein said Zener diode (301) comprises an anode connected to a third node (305) and a cathode connected to the first node (111), the capacitive element (303) comprising a first terminal connected to the third node (305) and a second terminal connected to the second node (113).

10. Device (300; 500; 700; 800) according to claim 8, wherein said Zener diode (301) comprises an anode connected to the second node (113) and a cathode connected to a third node (305), the capacitive element (303) comprising a first terminal connected to the third node (305) and a second terminal connected to the first node (111).

11. Device (500; 700; 800) according to any of claims 1 to 7, wherein said at least one Zener diode or at least one Shockley diode is a single Shockley diode (501).

12. Device (600; 700; 800) according to any of claims 1 to 7, wherein said at least one Zener diode or at least one Shockley diode comprises at least two diodes Zener or at least two Shockley diodes.

13. Device (300; 500; 600; 700; 800) according to any of claims 1 to 12, wherein the first and second terminals (109, 115) are intended to be connected to terminals of a connector, for example a Type-C USB connector.

14. Electronic device, preferably smartphone, connected object, touch tablet, or Type-C USB cable, comprising at least one device (300; 500; 600; 700; 800) of protection against electrostatic discharges according to any of claims 1 to 13.
